# EUROPEAN PATENT SPECIFICATION

(11) **EP 2 684 979 B1**
(45) Date of publication and mention of the grant of the patent: **12.08.2015**
(21) Application number: 12755703.1
(22) Date of filing: 30.01.2012
(51) Int. Cl.: C23C 16/44, H01L 21/31, H01L 21/683

(54) **VAPOR DEPOSITION APPARATUS**
DAMPFABSCHEIDUNGSVORRICHTUNG
APPAREIL DE DÉPÔT EN PHASE VAPEUR

(30) Priority: 09.03.2011 JP 2011051949
(43) Date of publication of application: 15.01.2014
(73) Proprietor: Taiyo Nippon Sanso Corporation, Tokyo 142-8558 (JP)
(72) Inventor: YAMAGUCHI, Akira, Tokyo 142-8558 (JP); UBUKATA, Akinori, Tokyo 142-8558 (JP)
(74) Representative: Hoefer & Partner Patentanwälte mbB
(86) International application number: PCT/JP2012/051966
(87) International publication number: WO 2012/120941

(56) References cited:
- WO-A1-99/05703
- JP-A- 2008 171 933
- JP-A- 2008 244 078
- JP-A- 2010 258 383
- JP-A- 2010 258 383
- JP-A- 2011 232 306
- US-A- 5 200 021
- US-A1- 2002 142 493

## Description

### Technical Field

The present invention relates to a vapor phase growth apparatus, and particularly to a rotation/revolution type vapor phase growth apparatus in which, while rotating/revolving a substrate, a thin film is epitaxially grown on the surface of the substrate by a chemical reaction using, in particular, a pyrolytic reaction of an organic metal.

### Background Art

As a vapor phase growth apparatus that allows for vapor phase growth on multiple substrates at a time, there is known a rotation/revolution type vapor phase growth apparatus in which a plurality of rotation susceptors are arranged in a circumferential direction of an outer peripheral portion of a revolution susceptor, and a bearing and an external gear are provided at outer peripheral portions of the rotation susceptors to engage a fixed internal gear provided inside a reactor vessel (chamber) with the external gear, thereby rotating/revolving the substrates during deposition (for example, see Patent Document 1). The occurrence of warpage on a substrate during deposition may have an influence on the quality of a manufactured thin film due to a change in the heating state of the substrate or a change in the flow of a gas. In particular, it is known that, in a MOCVD method that allows epitaxial growth in a chemical reaction using pyrolytic reaction of an organic metal, a small difference in the temperature of the surface of a substrate has a large influence on the quality of the substrate. For this reason, the state of the substrate is observed before the start of deposition to confirm the presence or absence of warpage of the substrate per se or the presence or absence of uplift of the substrate due to a dust (for example, see Patent Document 2). Further, JP 2010258383A discloses an apparatus according the preamble part of claim 1.

### Prior Art Documents

Patent Document

Patent Document 1 : JP A 2007-266121
Patent Document 2 : JP A 2005-5552

### Summary of the Invention

### Problem to be Solved by the Invention

In the technique described in Patent Document 2, however, since a measurement is carried out while moving the position measuring apparatus, a small displacement of the position measuring apparatus may be caused, which makes it difficult to carry out a measurement with high accuracy.

Accordingly, an object of the present invention is to provide a vapor phase growth apparatus provided with a measuring means which can measure the state of the warpage or inclination of the substrate with high accuracy.

### Means for Solving the Problem

In order to attain the above mentioned-object, the vapor phase growth apparatus according to the present invention is a rotation/revolution type vapor phase growth apparatus comprising a disk-shaped susceptor rotatably provided in a chamber,
a plurality of substrate retaining members rotatably provided at an equal interval in the circumferential direction of the outer peripheral portion of the susceptor,
a circular substrate retaining concave portion provided on the surface of the substrate retaining member,
a gas introducing portion which radially introduces a raw material gas to the front surface side of a susceptor from a center portion of the chamber,
an exhaust portion provided on the outer peripheral portion of the chamber and
a heating means which heats a substrate retained in the substrate retaining concave portion, and in which
the raw material gas is introduced to the front surface side of the susceptor from the gas introducing portion while rotating/revolving the substrate retaining member along with the rotation of the susceptor to perform vapor phase growth of a thin film on the surface of the substrate heated by the heating means, characterized in that
a measuring means for measuring warpage or inclination comprising a laser source which continuously emits a laser light in a direction perpendicular to the surface of the substrate which is retained in the substrate retaining concave portion and is rotating/revolving by the rotation of the susceptor and a light receiving portion which receives a laser light reflected on the surface of the substrate is fixed on the outer surface of a laser transparent portion provided on the chamber, and that
a judging means which judges that the substrate is in an abnormal state when the variation of the reflected light received by the light receiving portion is larger than a preset variation is provided wherein the number of revolutions of the substrate retaining member is set to a non-integral multiple of the number of revolutions of the susceptor.

Further, the vapor phase growth apparatus according to the present invention is characterized in that
the optical axis of the laser light of the laser source is arranged on the locus of the center of the substrate which is rotating/revolving, that
the judging means comprises an alarming means which alarms when the substrate is judged to be in an abnormal state, and that
the judging means judges a state of the substrate before vapor phase growth of a thin film is performed on the surface of the substrate and a state of the substrate after vapor phase growth of the thin film is performed on the surface of the substrate and comprises a storage means which stores the results of the judgments before and after the vapor phase growth individually.

### Effects of the Invention

By the vapor phase growth apparatus according to the present invention, since a rotating/revolving substrate is irradiated with a laser light in a state in which a laser source and a light receiving portion are fixed on a laser transparent portion provided on the chamber and the state of the substrate is judged by the state of the reflected light from the surface of the substrate, the positions of the laser source and the light receiving portion do not shift and a precise measurement can be carried out in a stable state. By arranging optical axis on the locus of the center of the substrate, the locus of the laser light with which the surface of the substrate is irradiated can be lengthened, and the state of the substrate can be judged using the center of the substrate as a reference point. Further, by setting the number of revolutions of the substrate retaining member to a non-integral multiple of the number of revolutions of the susceptor, since the orientation of the substrate when the substrate reaches the position of irradiation of the laser light by one rotation of the susceptor is different from that of another rotation, a plurality of points of the substrate can be measured and the state of the substrate can be measured more stably and with high accuracy.

### Brief Description of the Drawings

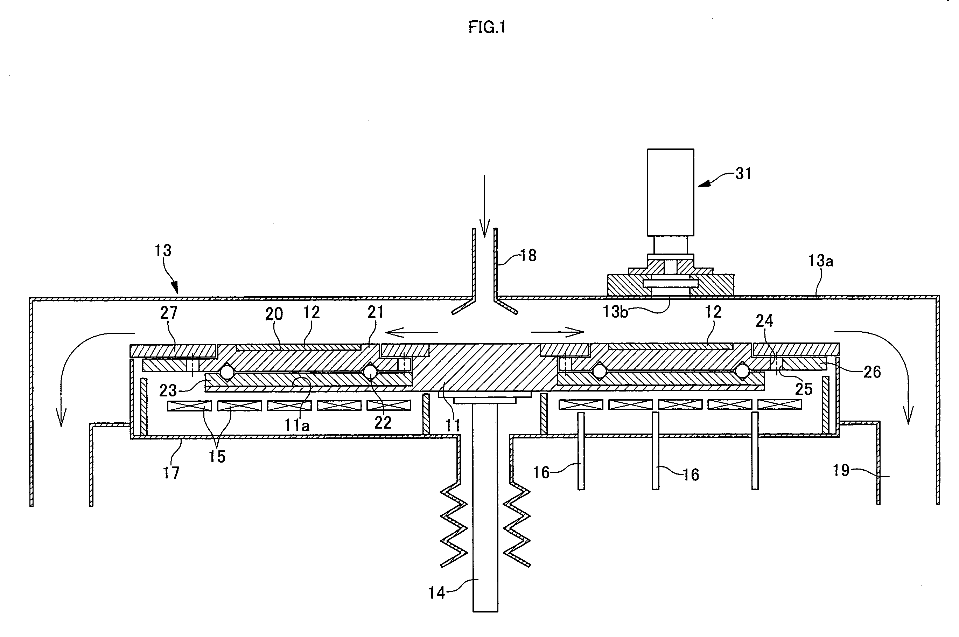

Fig. 1 is a cross-sectional view illustrating one embodiment of a vapor phase growth apparatus according to the present invention.

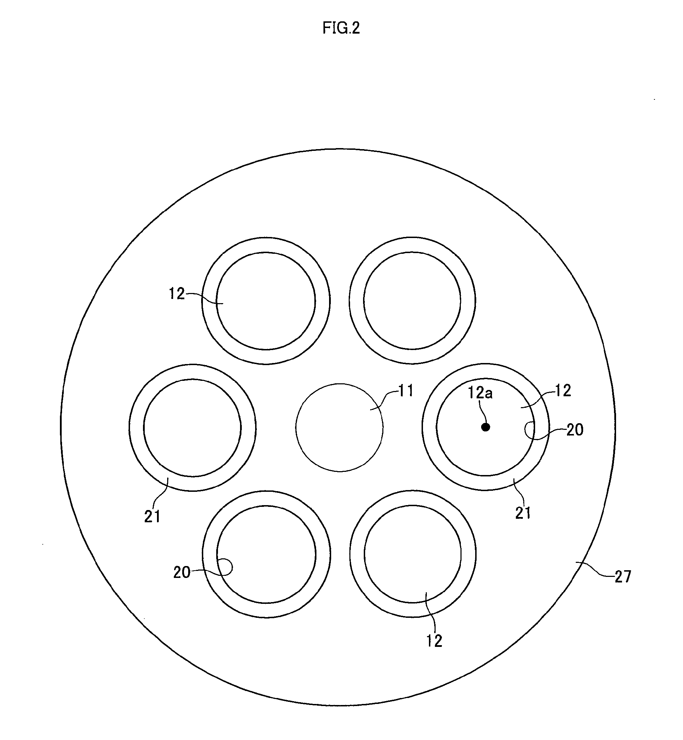

Fig. 2 is a plan view of a susceptor on which substrates are set.
Fig. 3 is an explanatory view illustrating loci of irradiation positions of a laser light on the surface of a substrate.
Fig. 4 is an explanatory view illustrating the state of a reflected light used for judgment by a judging means.

### Mode for Carrying out the Invention

The vapor phase growth apparatus illustrated in the present embodiment is a multiple rotation/revolution type vapor phase growth apparatus in which six substrates 12 can be mounted on the upper surface of a disk-shaped susceptor 11, wherein the susceptor 11 is rotatably provided inside a cylindrical chamber 13. On a center portion of the lower surface of the susceptor 11, a rotation axis 14; around the rotation axis 14, a heater 15 which is a heating means for heating the substrate 12 via the susceptor 11 and a thermometer 16 which measures a heating temperature are provided respectively. The lower portion and the surrounding of the heater 15 is covered with a reflector 17. A center of the top plate of a flow channel 13 has an opening for a gas introducing portion 18, and the outer periphery of the bottom plate thereof is provided with an exhaust port 19.

The substrate 12 is retained by a disk-shaped substrate retaining member (substrate tray) 21 having a substrate retaining concave portion 20 on the upper surface thereof; each substrate retaining member 21 is supported by each disk-shaped guide member 23 via a plurality of rolling members 22 formed of carbon or ceramics; and the guide member 23 is retained in a guide member retaining concave portion 11 a provided at an equal interval in the circumferential direction of the susceptor 11. At a lower portion of the outer periphery of the substrate retaining member 21, an external gear 24 is provided, and the outer peripheral position of the susceptor 11 is provided with a ring-shaped fixed gear member 26 having an internal gear 25 which meshes with the external gear 24 of the substrate retaining member 21. In addition, a cover member 27 which covers the upper portion of the fixed gear member 26, the upper portions of the internal gear 25 and external gear 24, and the upper surface of the center portion of the susceptor 11 is provided; and the upper surface of the cover member 27, the upper surface of the outer peripheral portion of the substrate retaining concave portion 20 and the upper surface of the substrate 12 are flush with each other.

In the case of performing vapor phase growth on the substrate 12, when the rotation axis 14 is rotated at a prescribed rate, the susceptor 11 integrated with the rotation axis 14 rotates and all members except a fixed gear member 28 rotate along with the rotation of the susceptor 11, whereby the substrate 12 rotates around the axis of the susceptor 11, i.e., becomes in a state of revolution. Because the internal gear 25 of the fixed gear member 26 meshes with the external gear 24, the substrate retaining member 21 rotates around the axis of the substrate retaining member 21, i.e., becomes in a state of rotation. By this, the substrate 12 retained by the substrate retaining member 21 rotates/revolves around the axis of the susceptor 11.

By introducing prescribed gas phase materials, for example, trimethylgallium and ammonia into the flow channel 13 from a gas phase material inlet 18 in a state in which the substrate 12 is rotated/revolved in such a manner and the substrate 12 is heated by the heater 15 via the susceptor 11 or the like at a prescribed temperature, for example, 1100°C, a prescribed thin film can be uniformly deposited on the surfaces of the plurality of substrates 12.

On a top plate 13a of the chamber 13 formed of a stainless steel, a laser transparent portion 13b formed of quartz glass which transmits a laser light is provided, and on the outer surface of the laser transparent portion 13b, in the present embodiment, on the upper surface of the top plate 13a, a substrate state judging unit31 is fixed. The substrate state judging unit31 incorporates a measuring means provided with a laser source which emits a laser light on the surface of the substrate and a light receiving portion which receives a laser light reflected on the surface of the substrate and a judging means which judges the state of the substrate based on the state of the reflected light received in the light receiving portion.

The laser source is arranged such that the optical axis of a laser light which the laser source emits is in the vertical direction with respect to the surface of the substrate on which a thin film is formed and is positioned on the locus of a center 12a of the rotating/revolving substrate 12. The light receiving portion is provided at a position where a reflected light which has been emitted from the laser source and reflected on the surface of the substrate can be received. The light receiving portion is formed such that it can receive the light within a preset range of the inclination the reflected light even when the optical axis of the reflected light is inclined due to the inclination of the surface of the substrate.

The number of revolutions of the substrate retaining member 21 is set to a non-integral multiple of the number of revolutions of the susceptor 11, whereby the orientation of the substrate retaining member 21 before the rotation of the susceptor 11 is different from that after the rotation of the susceptor 11 at one rotation. For example, when the number of teeth of the internal gear 25 is 360 and the number of teeth of the external gear 24 is 50, the substrate retaining member 21 rotates 7.2 rotations at one rotation of the susceptor 11. Every one rotation of the susceptor 11, the orientation of the substrate retaining member 21 shifts by 72 degrees. In such a manner, by setting the ratio between the numbers of revolutions to a non-integral number, different positions on the surface of the substrate which passes below the substrate state judging unit 31 can be irradiated with a laser light.

In the thus formed vapor phase growth apparatus, when the susceptor 11 is rotated along with the operation of the substrate state judging unit 31 in a state in which the substrate 12 is set in the substrate retaining concave portion 20 of each substrate retaining member 21, each of the surface of the substrate which passes below the substrate state judging unit 31 is successively irradiated with a laser light and the reflected light which is reflected in a direction in accordance with the inclination or the state of warp of the substrate 12 is received by the light receiving portion, and then the judging means judges that the state of the substrate is normal or abnormal.

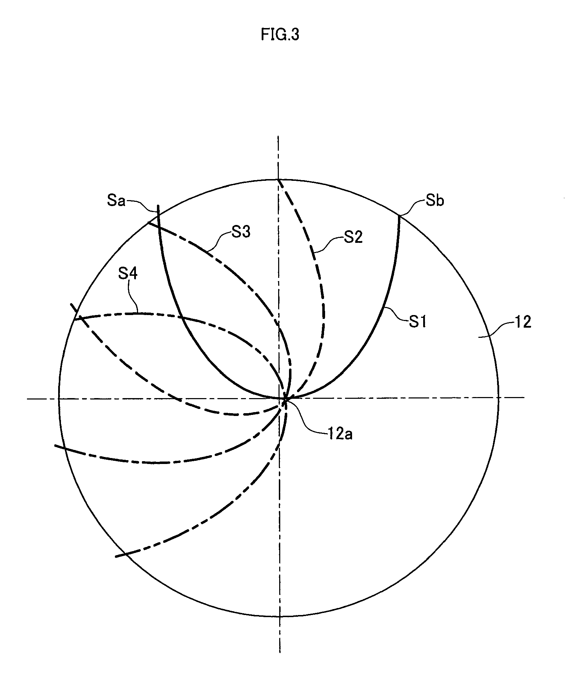

By setting the number of revolutions of the substrate retaining member 21 to a non-integral multiple of the number of revolutions of the susceptor 11, as illustrated in Fig. 3, with respect to the locus of the first irradiation position of a laser light (hereinafter, referred to as "scanning position") S1, a second scanning position S2, a third scanning position S3 and a fourth scanning position S4 individually pass different positions on the surface of the substrate. The reflected light depending on the state of the surface of the substrate at each scanning position is received by the light receiving portion and the state of the substrate 12 is judged based on each state in which the light is received.

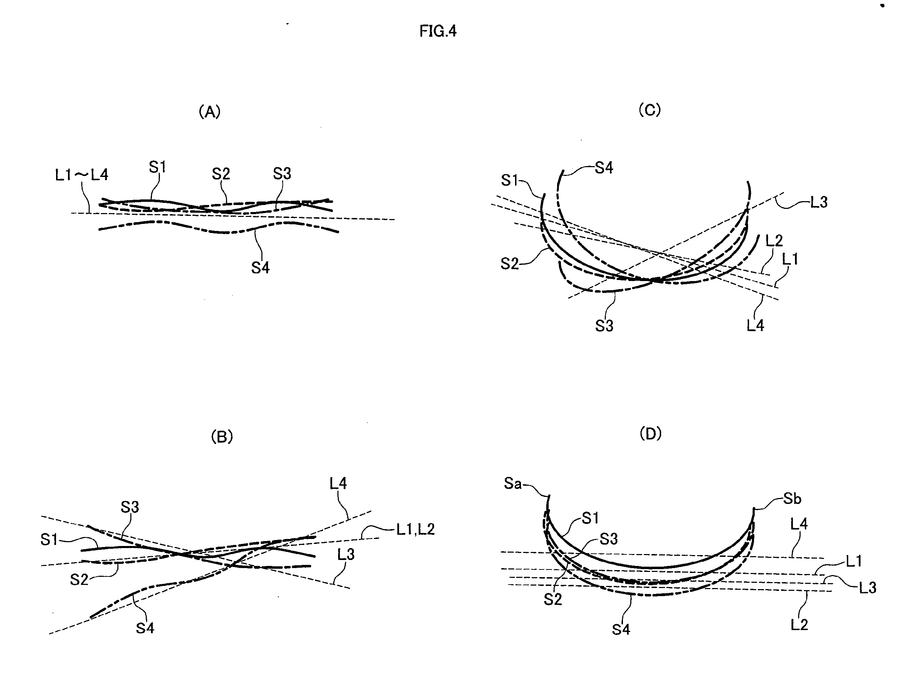

When a laser rangefinder is used as the substrate state judging unit 31, for each scanning position, the distance from at one point of the outer periphery of the substrate 12, an initial point Sa by way of the center of the substrate 12a to at another point of the outer periphery, an end point Sb are plotted as illustrated in Fig. 4. In Fig. 4, a part of lines are translated or the like for the ease of explanation.

In the case of Fig. 4(A), since at the scanning positions S1 to S4 the distances at the initial point Sa, the center of the substrate 12a and the end point Sb are about the same, it is found that the surface of the substrate is in parallel. A more or less irregularities along the line are due to the mechanical vibration when the substrate rotates. The influence by the mechanical vibration varies depending on the configuration of the apparatus or the design of the rotation system. As mentioned above, in the case of the mechanism in which the substrate is rotated/revolved by a gear, the vibration of the surface of the substrate which is due to the mechanical drive was about 30 µm irregularities. L1 to L4 which are values obtained by averaging the differential values of the surfaces of the substrate indicate about the same values, and the errors thereof were ±3 µm or less. Since the particle size of the particle which may affect the deposition is several 10 µm, it is suggested that this testing method is sufficiently applicable.

On the other hand, in the case of Fig. 4(B), although a substrate with a parallel plane is loaded, since on each of the scanning positions S1 to S4, the distance is about the same, the distance is shortened or the distance is lengthened at from the initial point Sa by way of the center of the substrate 12a to the end point Sb and the inclination of L1 to L4 each of which is the average of the differential at each point is different from each other, it can be judged that the surface of the substrate is inclined while being flat. The inclination of the surface of the substrate calculated by the difference between the inclinations of L4 and L1 the orientations of the inclinations of which are different from that of the other was about 50 µm. This was because a particle (dust) was attached to a part of the back surface of the substrate and the substrate was inclined. After the back surface was cleaned and the same substrate was loaded again, the same data as that in Fig. 4(A) can be obtained.

In the case of Fig. 4(C), a "warped substrate" having a film in advance was used. In each of the scanning positions S 1 to S4, a curve is drawn such that the distance is short at the initial point Sa, the distance is long at the center of the substrate 12a and the distance is short at the end point Sb, each of which represents that the surface of the substrate is in a state in which the center of the substrate 12a is at the bottom and the outer periphery thereof is lifted, i.e., in a state in which the surface of the substrate is warped in a concave shape. When a substrate having a film in advance is used, such a data may be obtained due to the warp of the surface of the substrate. The differentials of each the curves are averaged to obtain dotted lines L1 to L4. Different directions of the dotted lines suggest that the substrate rotates in a state in which it is inclined in one direction. The inclination of the surface of the substrate calculated by the difference between the inclinations of L3 and L1 the directions of which are different from that of the other was about 200 µm.

In the same manner as in the case of Fig. 4(B), after the back surface of the substrate was cleaned and the same substrate was tested again, the same data as illustrated in Fig. 4(D) was obtained. Since L1 to L4 represent the same inclination, it can be judged that a dust on the back surface has been removed.

By setting the substrate 12 and measuring the state of the surface of the substrate by the substrate state judging unit 31 while rotating the susceptor 11, the state of the warpage of the surface of the substrate and the state of the inclination of the surface of the substrate can be measured in such a manner, and the acceptable range of the variation of the warpage and the acceptable range of the variation of the inclination are therefore preset and when the measured warpage or inclination of the surface of the substrate is larger than the acceptable range, it is judged that the substrate 12 is in an abnormal state. For example, when the substrate 12 is inclined because a dust is caught between the substrate retaining concave portion 20 and the substrate 12, since judgment results as illustrated in Fig. 4(B) and Fig. 4(C) are obtained, the substrate 12 is taken out from the substrate retaining concave portion 20 and the states of the substrate retaining concave portion 20 and the substrate 12 are confirmed, and then a cleaning operation which removes a dust is carried out, followed by setting the substrate 12 on the substrate retaining concave portion 20 again, which eliminates the state of inclination of the substrate 12 and allows to start the deposition operation on the substrate 12 in a normal state. In the case of a substrate 12 having a warpage larger than the acceptable range, the substrate 12 is replaced. A deposition operation which wastes a raw material gas for the substrate 12 can be eliminated. Further, by providing the substrate state judging unit 31 with an alarming function which puts a buzzer or a warning light in operation when it is judged that the state of the substrate 12 is abnormal and by informing the operator of the presence of an abnormal state, the cleaning operation or the replacement of the substrate can be surely carried out.

Preferably, the judgment criteria for a dust on the back surface of the substrate is whether or not the particle size of the dust is "30 µm or larger and 500 µm or smaller". When the particle size of the dust is 30 µm or smaller, the judgment may not be sufficiently carried out due to the insufficiency of measurement accuracy; and when the particle size of the dust is 500 µm or larger, the measurement cannot be carried out in some cases because the reflected laser light misses the light receiving portion. By setting the substrate 12 and measuring the state of the surface of the substrate by the substrate state judging unit 31 while rotating the susceptor 11 in such a manner, the state of the warpage of the surface of the substrate and the state of the inclination of the surface of the substrate can be comprehended.

After judging that all of the substrates 12 are normal in such a manner, the raw material gas is introduced to the front surface side of the susceptor from the gas introducing portion 18 while rotating/revolving the substrate retaining member 21 which retains the substrate 12 along with the rotation of the susceptor 11 in which the rotation axis 14 is driven, to perform vapor phase growth of a thin film on the surface of the substrate heated to a prescribed temperature by the heater 15.

Since this avoids vapor phase growth on a substrate 12 which is largely inclined or largely warped, the raw material gas can be effectively used as well as a uniform thin film can be formed on the surface of the substrate, thereby improving the quality or the yield thereof. In particular, in the MOCVD method which is largely influenced by the temperature variation of the surface of a substrate, the temperature distribution of the surface of the substrate can be eliminated and the reproducibility of the in-plane distribution can be secured, whereby a high quality thin film can be effectively and stably obtained.

Since the substrate state judging unit 31 is fixed on the chamber 13, the distance between the substrate state judging unit 31 and the surface of substrate and the angle thereof with respect to the surface of substrate do not change, whereby an accurate judgment can always be carried out.

Further, by judging, before and after the vapor phase growth, the states of the substrate respectively and storing the judgment results in a storage means, when the formed thin film has an abnormality, whether the abnormality is caused by the state of the substrate or not can be easily judged and the cause of the abnormality can be more easily pursued than ever before.

Any number of substrates may be processed and any method of introducing a raw material gas may be employed, and such a substrate state judging unit can be applied to a variety of rotation/revolution type vapor phase growth apparatuses. As the measuring means in the substrate state judging unit, a variety of commercially available measuring instruments which detect a distance or displacement by a laser can be utilized. A measuring means provided with a laser source and a light receiving portion and a judging means may be separately disposed, and a variety of display means, printing means and storage means may be connected to the substrate state judging unit. To the laser transparent portion, a variety of means for stabilizing a laser light can be added.

Although, by setting the measuring means such that the laser light thereof passes the center of the substrate, the state of the whole of the surface of the substrate can be surely measured, even when the position of the measuring means is off the center of the substrate, or when the position of the measuring means is near the center of the substrate, the state of the surface of the substrate can be known to some extent. Further, when the number of revolutions of the substrate retaining member is an integral multiple of the number of revolutions of the susceptor, a laser light passes the same position on the surface of the substrate. The state of the surface of the substrate can be known to some extent also in this case. In cases where the direction of the substrate retaining member shifts 180° when the susceptor rotates one rotation, two points on the surface of the substrate are to be measured; and in cases where the direction of the substrate retaining member shifts 120° when the susceptor rotates one rotation, three points on the surface of the substrate are to be measured. The ratio of the both numbers of revolutions is therefore preferably set to a ratio avoiding a shift of 180° or 120° even when the ratio is set to a non-integral number.

### Description of Symbols

- 11: Susceptor
- 11a: Guide member retaining concave portion
- 12: Substrate
- 12a: Center of the substrate
- 13: Chamber
- 13a: Top plate
- 13b: Laser transparent portion
- 14: Rotation axis
- 15: Heater
- 16: Thermometer
- 17: Reflector
- 18: Gas introducing portion
- 19: Exhaust port
- 20: Substrate retaining concave portion
- 21: Substrate retaining member
- 22: Rolling member
- 23: Guide member
- 24: External gear
- 25: Internal gear
- 26: Fixed gear member
- 27: Cover member
- 31: Substrate state judging unit

## Claims

1. A rotation/revolution type vapor phase growth apparatus comprising
a disk-shaped susceptor (11) rotatably provided in a chamber (13),
a plurality of substrate retaining members (21) rotatably provided at an equal interval in the circumferential direction of the outer peripheral portion of the susceptor,
a circular substrate retaining concave portion (20) provided on the surface of the substrate retaining member (21),
a gas introducing portion (18) which radially introduces a raw material gas to the front surface side of a susceptor from a center portion of the chamber,
an exhaust portion (19) provided on the outer peripheral portion of the chamber and
a heating means (15) which heats a substrate (12) retained in the substrate retaining concave portion (20), and in which
the raw material gas is introduced to the front surface side of the susceptor from the gas introducing portion (18) while rotating/revolving the substrate retaining member (21) along with the rotation of the susceptor to perform vapor phase growth of a thin film on the surface of the substrate (12) heated by the heating means (15),
wherein a measuring means for measuring warpage or inclination comprising a laser source which continuously emits a laser light in a direction perpendicular to the surface of the substrate (12) which is retained in the substrate retaining concave portion (20) and is rotating/revolving by the rotation of the susceptor and a light receiving portion which receives a laser light reflected on the surface of the substrate is fixed on the outer surface of a laser transparent portion provided on the chamber, and
wherein a judging means (31) which judges that the substrate is in an abnormal state when the variation of the reflected light received by the light receiving portion is larger than a preset variation is provided,
**characterized in that**
the number of revolutions of the substrate retaining member is set to a non-integral multiple of the number of revolutions of the susceptor.

2. The vapor phase growth apparatus according to claim 1, wherein the optical axis of the laser light of the laser source is arranged on the locus of the center of the substrate which is rotating/revolving.

3. The vapor phase growth apparatus according to claims 1 or 2, wherein the judging means comprises an alarming means which alarms when the substrate is judged to be in an abnormal state.

4. The vapor phase growth apparatus according to claims 1 to 3, wherein the judging means is configured to judge a state of the substrate before vapor phase growth of a thin film is performed on the surface of the substrate and a state of the substrate after vapor phase growth of the thin film is performed on the surface of the substrate and to comprise a storage means which stores the results of the judgments before and after the vapor phase growth individually.

## Patentansprüche

1. Drehende/rotierende Dampfphasenwachstums-Vorrichtung, umfassend:
- einen scheibenförmigen Suszeptor (11), der drehbar in einer Kammer (13) vorgesehen ist,
- eine Mehrzahl von Substrat-Halteelementen (21), die drehbar in gleichen Abständen in Umfangsrichtung des äußeren Umfangsbereichs des Suszeptors vorgesehen sind,
- einen kreisförmigen konkaven Substrat-Haltebereich (20), der auf der Fläche des Substrat-Halteelements (21) vorgesehen ist,
- einen Gaseinleitungsbereich (18), der radial ein Rohgas zur vorderen Flächenseite eines Suszeptors von einem Mittelbereich der Kammer einleitet,
- einen Auslassbereich (19), der auf dem äußeren Umfangsbereich der Kammer vorgesehen ist, und
- eine Heizeinrichtung (15), die ein Substrat (12) aufheizt, das im konkaven Substrat-Haltebereich (20) gehalten wird, und in die
- das Rohgas zur vorderen Flächenseite des Suszeptors vom Gaseinleitungsbereich (18) eingeleitet wird, während das Substrat-Halteelement (21) zusammen mit der Drehung des Suszeptors gedreht/rotiert wird, um das Dampfphasenwachstum eines dünnen Films auf die Fläche des Substrats (12) auszuführen, das durch die Heizeinrichtung (15) aufgeheizt wird,
- wobei eine Messeinrichtung zum Messen einer Wölbung oder Neigung eine Laserquelle aufweist, die kontinuierlich ein Laserlicht in eine Richtung abgibt, die senkrecht zur Fläche des Substrats (12) ist, dass im konkaven Substrat-Haltebereich (20) gehalten und durch die Drehung des Suszeptors gedreht/rotiert wird, und wobei ein Lichtaufnahmebereich, der ein Laserlicht aufnimmt, dass auf die Fläche des Substrats reflektiert wird, auf der äußeren Fläche eines lasertransparenten Bereich fixiert ist, der auf der Kammer vorgesehen ist, und
- wobei eine Bestimmungseinrichtung (31) vorgesehen ist, die bestimmt, dass sich das Substrat in einem anormalen Zustand befindet, wenn die Änderung des reflektierten Lichts, das durch den Lichtaufnahmebereich aufgenommen wird, größer als eine voreingestellte Änderung ist,
**dadurch gekennzeichnet, dass**
- die Drehzahl des Substrats-Halteelements auf ein nicht ganzzahliges Vielfaches der Drehzahl des Suszeptors festgelegt ist.

2. Dampfphasenwachstums-Vorrichtung gemäß Anspruch 1, wobei die optische Achse des Laserlichts der Laserquelle auf der Ortskurve des Mittelpunkts des Substrats, das sich dreht/rotiert, angeordnet ist.

3. Dampfphasenwachstums-Vorrichtung gemäß Anspruch 1 oder 2, wobei die Bestimmungseinrichtung eine Alarmeinrichtung aufweist, die Alarm auslöst, wenn bestimmt wird, dass sich das Substrat in einem anormalen Zustand befindet.

4. Dampfphasenwachstums-Vorrichtung gemäß einem der Ansprüche 1 bis 3, wobei die Bestimmungseinrichtung eingerichtet ist, um einen Zustand des Substrats zu bestimmen, bevor das Dampfphasenwachstum eines dünnen Films auf der Fläche des Substrats ausgeführt wird, und um einen Zustand des Substrats zu bestimmen, nachdem das Dampfphasenwachstum des dünnen Films auf der Fläche des Substrats ausgeführt ist, und um eine Speichereinrichtung aufzuweisen, die die Ergebnisse der Bestimmungen vor und nach dem Dampfphasenwachstum einzeln speichert.

## Revendications

1. Appareil de croissance en phase vapeur du type à rotation/révolution comprenant
un suscepteur en forme de disque (11) prévu en rotation dans une chambre (13),
une pluralité d'éléments de retenue de substrat (21) prévus en rotation à un intervalle égal dans la direction circonférentielle de la partie périphérique extérieure du suscepteur,
un partie concave de retenue de substrat circulaire (20) prévue sur la surface de l'élément de retenue de substrat (21),
une partie d'introduction de gaz (18) qui introduit de manière radiale un gaz de matière première au côté de surface avant d'un suscepteur à partir d'une partie centrale de la chambre,
une partie d'échappement (19) prévue sur la partie périphérique extérieure de la chambre et
un moyen de chauffage (15) qui chauffe un substrat (12) retenu dans la partie concave de retenue de substrat (20), et dans lequel
le gaz de matière première est introduit au côté de surface avant du suscepteur à partir de la partie d'introduction de gaz (18) tout en effectuant une rotation/révolution de l'élément de retenue de substrat (21) avec la rotation du suscepteur pour effectuer une croissance en phase vapeur d'un film mince sur la surface du substrat (12) chauffé par le moyen de chauffage (15),
dans lequel un moyen de mesure permettant de mesurer un gauchissement ou une inclinaison comprenant une source laser qui émet en continu une lumière laser dans une direction perpendiculaire à la surface du substrat (12) qui est retenu dans la partie concave de retenue de substrat (20) et effectue une rotation/révolution par la rotation du suscepteur et une partie de réception de lumière qui reçoit une lumière laser réfléchie sur la surface du substrat est fixée sur la surface extérieure d'une partie transparente au laser prévue sur la chambre, et
dans lequel un moyen de jugement (31) qui juge que le substrat est dans un état anormal lorsque la variation de la lumière réfléchie reçue par la partie de réception de lumière est supérieure à une variation prédéfinie est prévu,
**caractérisé en ce que**
le nombre de révolutions de l'élément de retenue de substrat est réglé à un multiple non entier du nombre de révolutions du suscepteur.

2. Appareil de croissance en phase vapeur selon la revendication 1, dans lequel l'axe optique de la lumière laser de la source laser est agencé sur le locus du centre du substrat qui effectue une rotation/révolution.

3. Appareil de croissance en phase vapeur selon la revendication 1 ou 2, dans lequel le moyen de jugement comprend un moyen d'avertissement qui avertit lorsque le substrat est jugé comme étant dans un état anormal.

4. Appareil de croissance en phase vapeur selon les revendications 1 à 3, dans lequel le moyen de jugement est configuré pour juger un état du substrat avant qu'une croissance en phase vapeur d'un film mince ne soit effectuée sur la surface du substrat et un état du substrat après qu'une croissance en phase vapeur du film mince est effectuée sur la surface du substrat et pour comprendre un moyen de stockage qui stocke les résultats des jugements avant et après la croissance en phase vapeur individuellement.
